# EUROPEAN PATENT SPECIFICATION

(11) **EP 0 590 148 B1**
(45) Date of publication and mention of the grant of the patent: **07.04.1999**
(21) Application number: 90916811.4
(22) Date of filing: 19.11.1990
(51) Int. Cl.: C23C 14/22, C23C 16/44, C30B 11/00, C30B 23/00, C30B 25/00, G11B 5/31, H01L 21/203

(54) **METHOD AND APPARATUS FOR THIN FILM FORMATION, DEVICE, ELECTRO-MAGNETIC APPARATUS, DATA RECORDING/REPRODUCTION APPARATUS AND SIGNAL PROCESSOR**
VERFAHREN UND VORRICHTUNG ZUR DÜNNSCHICHTBILDUNG, ANLAGE, ELEKTROMAGNETISCHES GERÄT, AUFZEICHNUNGS/WIEDERGABEVORRICHTUNG UND SIGNALPROZESSOR
PROCEDE ET APPAREIL DE FORMATION DE MINCES PELLICULES, DISPOSITIF, APPAREIL ELECTROMAGNETIQUE, APPAREIL D'ENREGISTREMENT/LECTURE DE DONNEES ET PROCESSEUR DE SIGNAUX

(30) Priority: 19.11.1989 JP 300177/89
(43) Date of publication of application: 06.04.1994
(73) Proprietor: KABUSHIKI-KAISHA HITACHI SEISAKUSHO, Chiyoda-ku Tokyo 101 (JP); NIHON VICTOR KABUSHIKI-KAISHA, Kanagawa-ku Yokohama-shi Kanagawa-ken 221 (JP); TAKAHASHI, Migaku, Miyagi-ken 980-02 (JP)
(72) Inventor: TAKAHASHI, Migaku, Sendai-shi Miyagi-ken 980-02 (JP); YOKOYAMA, Katsuya Nihon Victor Kabushiki-kaisha, Yokohama-shi Kanagawa-ken 221 (JP); YAMADA, Jun K.K.Hitachi Seisakusho Kaden Kenkyusho, Yokohama-shi Kanagawa-ken 244 (JP); SHIBA, Takashi K.K. Hitachi Seisakusho, Yokohama-shi Kanagawa-ken 244 (JP)
(74) Representative: Weitzel, Wolfgang, Dr.-Ing.
(86) International application number: JP9001507
(87) International publication number: WO9107520

(56) References cited:
- JP-A- 1 261 298
- JP-A- 1 261 298
- JP-A- 1 317 112
- JP-A- 1 317 112
- JP-A-63 285 194
- JP-A-64 079 090
- US-A- 3 654 574
- IBM TECHNICAL DISCLOSURE BULLETIN., vol.16, no.11, April 1974, NEW YORK US pages 3813 - 3814 BRADY AND SADAGOPAN 'Acoustic surface wave induced control of grain size in thin films'

## Description

### SPECIFICATION

### TECHNICAL FIELD

The present invention relates to a method and an apparatus for preparing thin films, a device, an electronic and magnetic apparatus, an information recording and reproducing apparatus, an information processing apparatus.

### BACKGROUND OF THE INVENTION

In recent years, various techniques have been proposed with reference to methods for forming thin films and for preparing crystal. Thin film forming methods such as evaporation, sputtering, CVD and the like are described in "Thin film Handbook" ed. by the Japan Society for the Promotion of Science (Ohm), and as to single crystal forming method, for example, Czochralski method and zone melting method are well known, as described in "Crystal Technology Handbook" ed. by the Compilation Committee of kessho-kogaku handbook (Kyoritu Shuppan).

Further prior art references are:
(1) JP-A-1-261298
(2) JP-A-1-317112
(3) IBM Technical Disclosure Bulletin April 1974, No. 11, Vol. 16, 3813-3814
(4) US-A-3654574

JP-A-1-261298 describes the synthesis of diamond constituted of fine polycrystals of high crystal nucleus density, outstanding in adherability, by low-pressure vapor synthesis through the CVD process while vibrating a base substance. According to this the interior of a reaction chamber consisting of e. g. a quartz tube is kept under a pressure of 10⁻⁵ - 10⁻³, and a microwave generated by a magnetron is irradiated on a raw material gas such as CO+H₂ introduced into said chamer through a waveguide to excite and decompose the raw material gas. A base substance is held on its holder in the reaction chamber and heated by a heating means along with application a supersonic vibration from a supersonic vibration generator. Hence, plasma particles produced by excitation and decomposition of the raw material gas are emitted on the base substance und vibration heated at 400 - 1200°C, thus forming the objective diamond on the base substance in high adhesiveness.

From JP-A-1-317112 it is known to produce a polycrystalline diamond having high strength and dense texture suitable for the use in a field required to have high strength, e. g. material for machining tool, by depositing diamond on a substrate while applying vibration to the diffusion boundary layer of carbon on the surface of the substrate. According to this method diamond is deposited on a substrate by a vapor-phase synthesis comprising the activation of a gaseous mixture composed mainly of an organic carbon compound with plasma discharge, etc., by thermionic emission, high-frequency radiation or microwave radiation. In the process according to JP-A-1-317112 the deposition of diamond is performed while applying a vibration to the diffusion boundary layer of carbon on the surface of the substrate, e. g. by mechanically vibrating the substrate using supersonic vibration. A dense and high-strength polycrystalline diamond can be produced by this process and the product is especially suitable as a various tools such as cutting tools, dilling tool or dresser.

From IBM Technical Disclosure Bulletin, April 1974, No. 11, Vol. 16, 3813 - 3814 it is known to control the grain size through in situ generation and propagation of acoustic surface waves during the nucleation and growth phase of film fabrication. Scattered energy from the ultrasonic beam controles the grain size.

US-A-3654574 shows an acoustic-wave transmitting system comprising a substrate capable of propagating acoustic surface waves. Disposed near opposite end of the substrate are an input transducer that responds to an input signal for launching acousting surface waves and an output transducer that responds to those waves for developing an output signal which is fed to a load. Extending lengthwise down the center of the wave-propagating surface is an acoustic wave guide that concentrates acoustic surface waves along a propagation path between the two transducers. Each of the transducers includes a pair of interleaved combs of conductive electrodes coupled piezoelectrically to the substrate. Adjacent teeth in the combs are spaced apart by one-half the acoustic wavelength and are curved concavely toward the adjacent end of the strip.

The prior art techniques mentioned above are effective for the control of crystal growth, but no effect of mechanical oscillation on the crystal growth surface has been taken into consideration.

The purpose of the present invention is to provide a thin film forming method and a thin film forming apparatus which take advantage of the effect of mechanical oscillation on crystal growth at the initial stage of crystal growth.

Another purpose of the present invention is to provide a device having a thin film prepared by taking advantage of the effect of mechanical oscillation on crystal growth at the initial stage of crystal growth.

### DISCLOSURE OF THE INVENTION

The first aim of the present invention is to provide a method for forming a thin film on the surface of a substrate according to Claim 1.

The second aim of the present invention is to provide a thin film forming apparatus for forming a crystal thin film on the surface of the substrate according to Claim 4.

The third aim of the present invention is to provide a device comprising a substrate and a crystal thin film with at least one layer prepared thereon, according to Claim 13.

The fourth aim of the present invention is to provide an electric and magnetic apparatus according to Claim 20.

The fifth aim of the present invention is to provide an information recording and reproducing apparatus according claim 25.

The sixth aim of the present invention is to provide an information processing apparatus for in use in input, record process and output of information according to claim 26.

### OPERATION

The present inventor has found out that the structure of crystal grain is changed by the mechanical oscillation put on the crystal growing surface at the initial stage of crystal growth. According to this finding, it becomes possible to control crystal growth by oscillation as mentioned above, then to form various thin films having excellent characteristics, and consequently to construct various devices and electronic and magnetic apparatus with high reliability. It is also possible to provide an information recording and reproducing apparatus with low error rate and an information processing device with high processing rate.

### BRIEF DESCRIPTION OF THE DRAWINGS

Fig. 1 is a perspective view illustrating the 1st embodiment of the invention.

Fig. 2 is a fragmentary sectional view of a film forming apparatus in accordance with embodiment 1.

Fig. 3 is a plan view of parts in accordance with embodiment 1.

Fig. 4 is a graph showing the relation between applied voltage and the rise in substrate temperature in accordance with embodiment 1.

Fig. 5 is a graph showing the anisotropic magnetic field Hk as a function of applied voltage, excited amplitude, or substrate temperature in accordance with embodiment 1.

Fig. 6 is a graph showing the structure factor as a function of applied voltage, excited amplitude, or substrate temperature in accordance with embodiment 1.

Fig. 7 is a graph showing the coercive force as a function of applied voltage, excited amplitude, or substrate temperature in accordance with embodiment 1.

Fig. 8 is an SEM image of the film prepared at room tempesature ( without excitation) in accordance with embodiment 1.

Fig. 9 is an SEM image of the film prepared at applied voltage of 8V in accordance with embodiment 1.

Fig. 10 is an SEM image of the film prepared at applied voltage of 9V in accordance with embodiment 1.

Fig. 11 is a sectional view of the crystal forming furnace in accordance with embodiments 2 and 3.

Fig. 12 is a schematic diagram showing a method of SAW excitation in accordance with embodiment 4.

Fig. 13 is a schematic diagram showing a method of SAW excitation in accordance with embodiment 5.

Fig. 14 is a schematic diagram showing a method of SAW excitation in accordance with embodiment 6.

Fig. 15 is a plan view in accordance with embodiment 7.

Fig. 16 is a sectional view of a thin film magnetic head in accordance with embodiment 8.

Fig. 17 is a schematic diagram showing a method for constructing a magnetic disk in accordance with embodiment 9.

Fig. 18 is a schematic diagram showing a part of the interconnecting pattern in accordance with embodiment 10.

Fig. 19 is a schematic diagram showing a prior art MBE method.

Fig. 20 is a schematic diagram showing a method of forming superlattice thin film in accordance with embodiment 11.

Fig. 21 is a schematic diagram showing a method for forming a Josephson device in accordance with embodiment 11.

Fig. 22 is a schematic diagram showing a magnetic recording and reproducing apparatus in accordance with embodiment 13.

Fig. 23 is a fragmentary sectional view of an integrated circuit in accordance with embodiment 14.

Fig. 24 is a block diagram showing an electronic computer system in accordance with embodiment 15.

A list of parts and numerals shown in the figures is as follows:
- 1,20,23;: Substrate,
- 2,19,43;: Interdigital electrode,
- 5;: Surface acoustic wave (SAW),
- 6,35;: Thin film formed area,
- 7;: Flow of particles,
- 17;: Ultrasonic oscillator,
- 24;: Wedge-shaped oscillator,
- 25;: Reflector,
- 26,27;: Group of interdigital electrodes,
- 33;: Lower core,
- 34;: Upper core,
- 36,44;: Magnetic disk,
- 37,38;: Interconnector,
- 39;: Interlayer insulator,
- 41;: Atom,
- 42;: Superconductor thin film,
- 51;: Source electrode or drain electrode,
- 52;: Gate electrode.

### DESCRIPTION OF THE PREFERRED EMBODIMENTS

### (Embodiment 1)

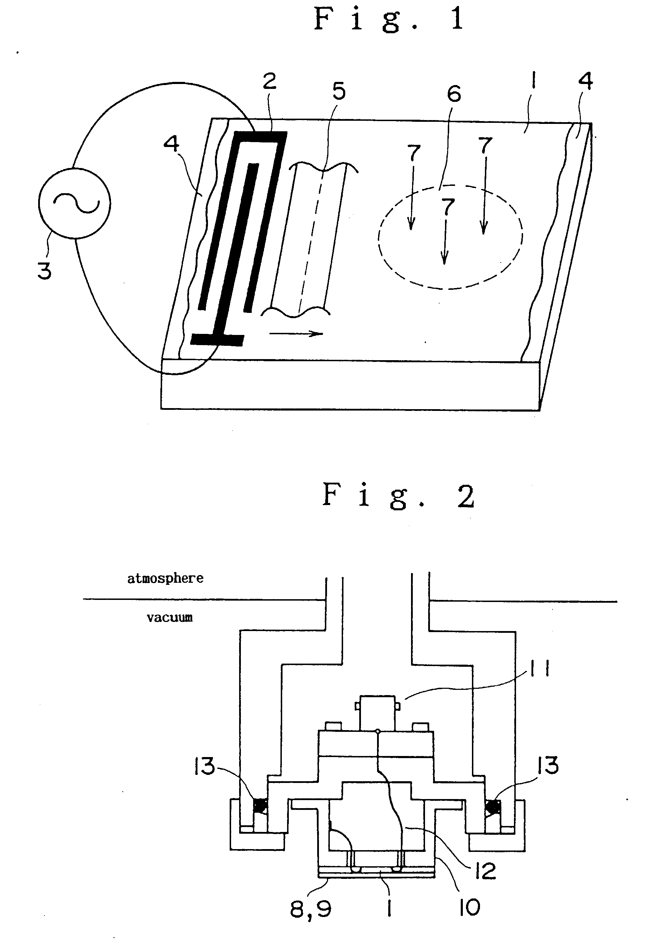

The first embodiment of the present invention will be described below, referring to Figures 1 - 10.

In this embodiment, a 128° Y-K cut LiNbO₃ crystal 1 was used as a substrate and interdigital electrodes 2 were formed on the substrate.

Surface acoustic wave was generated by applying a high frequency electric field (45 MHz) to both ends of the interdigital electrodes through a signal source 3.

Acoustic absorbers 4 were coated near the edges of the substrate to reduce the reflection of SAW. A mask 9 restricting flow of the particles 7 was mounted on the substrate and then thin a film was prepared on an area 6 by D.C. sputtering with a Permalloy target having composition of 83 wt% Ni, 15.7 %Fe, 1 %Mo and 0.3 % others.

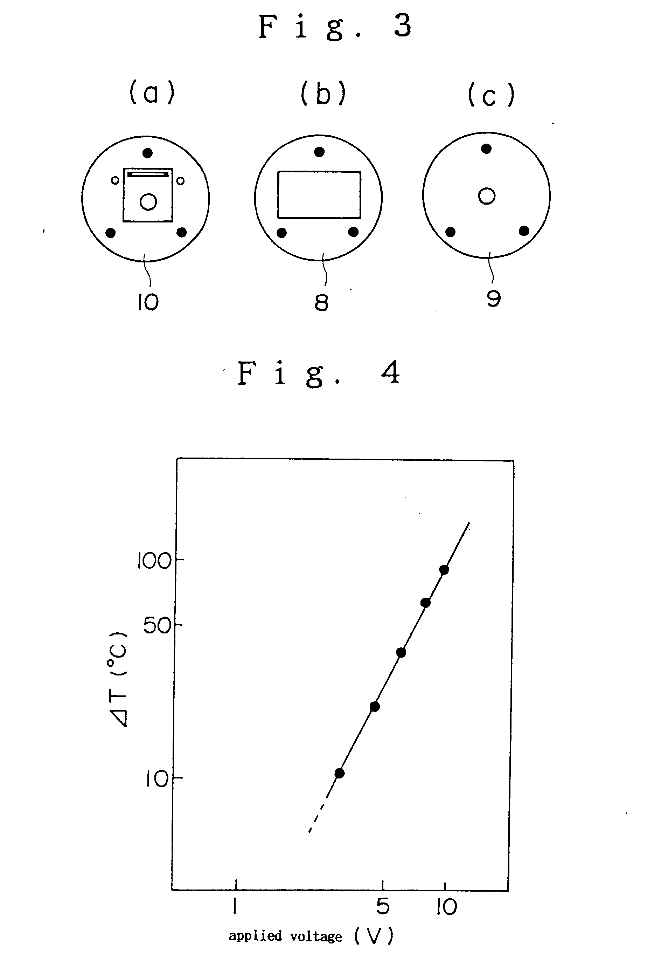

Fig. 2 shows a fragmentary sectional view of a substrate holder of a sputtering apparatus used in this embodiment. The substrate 1 was fixed on a holder body 10 by a substrate retainer 8 and then a mask was mounted on the retainer 8. High frequency signal was supplied to the interdigital electrodes 2 from electric source terminal 11 through conductive wire 12. The vacuum of a film forming chamber was maintained with an o-ring seal 13. Fig. 3 shows enlarged views of the holder body 10, the retainer 8 and the mask 9.

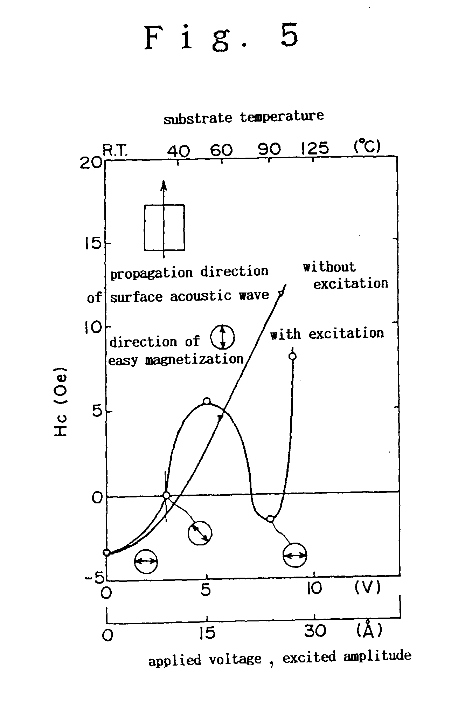

Most energy of SAW generated through electrode 2 is absorbed by acoustic absorbers 4 and converted to heat. Therefore, the temperature of the substrate will rise with the increase in voltage of the signal source 3. Fig. 4 shows the relation between the applied voltage and the rise in substrate temperature. The temperature was obtained from the measurement on deviation of passing frequency characteristics from the pole performed by constructing a few pairs of interdigital electrodes on the substrate. The small number of the pairs reduces the effect on SAW.

The thin film was prepared at pressure of 0,78 Pa (6 mtorr) and at deposition rate of 30 nm/min. Fig. 5 represents anisotropic magnetic field Hc as a function of applied voltage through signal source, temperature of the substrate, or amplitude of SAW. The temperature was obtained from the relationship shown in Fig. 4, and the amplitude from conductance of the device and aperture. In the case of no SAW excitation, the substrate was heated by a heater to the same temperature as that in the case of excitation. In Fig. 5, there is a remarkable difference of anisotropic magnetic field Hk between without excitation and with excitation at applied voltage of about 8V, which corresponds to 1,5-3,0 nm (15-30Å) in amplitude of excitation. Namely, it is apparent from the figure that direction of easy magnetization is changed by excitation.

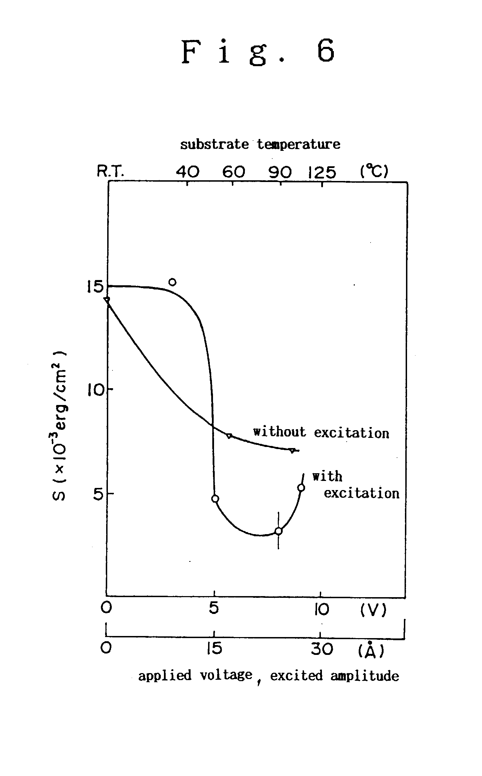

Similarly, Fig. 6 shows the structure factor S as a function of applied voltage, temperature of the substrate or amplitude of SAW. The structure factor S was obtained by the measurement of dynamic differential susceptibility. The measurement method is described in detail in "The Transaction of the Institute of Electronics, Information and Communication Engineers; Transaction on Magnetic Recording MR89- (1989)."

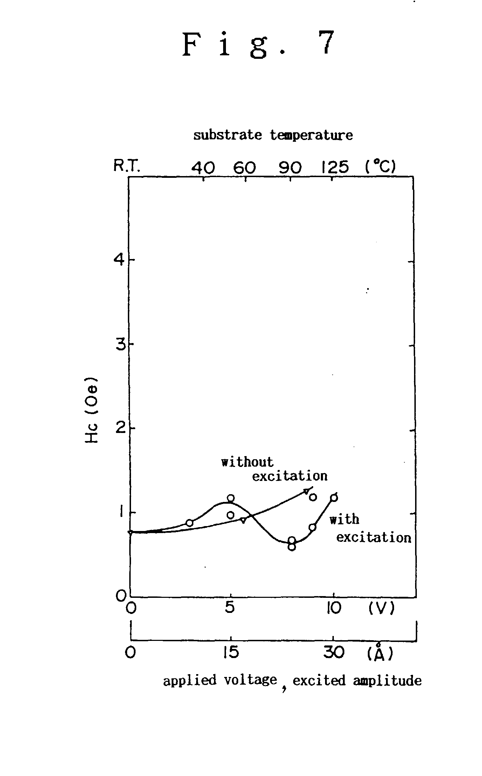

Fig 7 shows the saturation magnetization Hc as a function of applied voltage, temperature of the substrate, excitation amplitude. In Figures 6 and 7, drastic differences are observed around 8 V between curves. It can be presumed from these results that the crystal grain prepared at applied voltage of 8V is small.

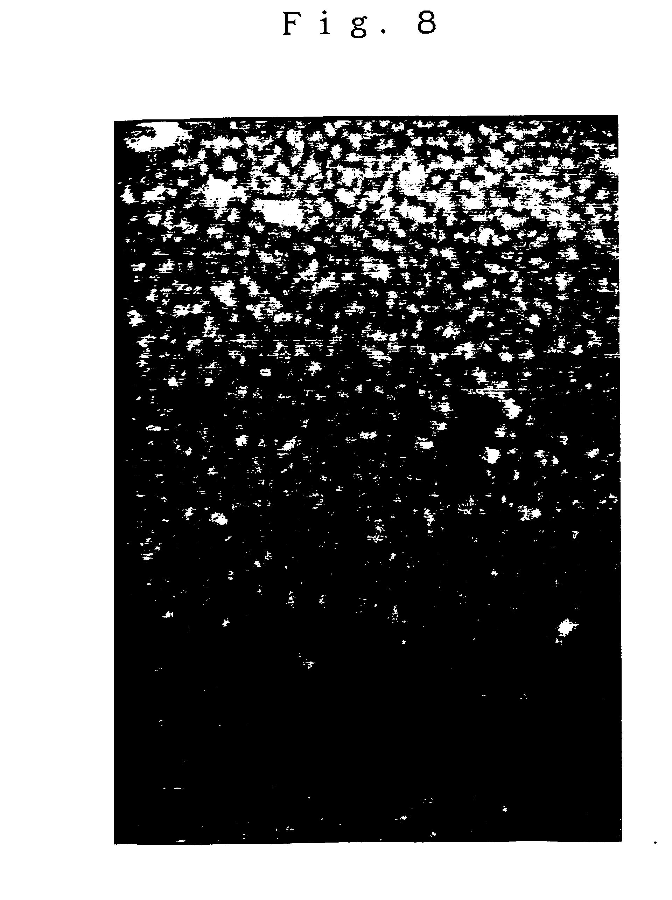

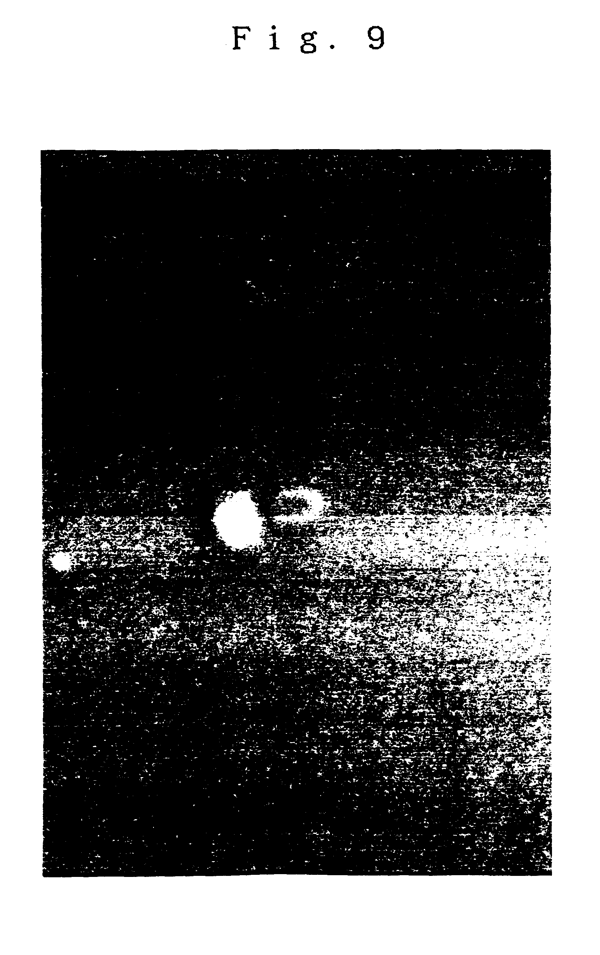

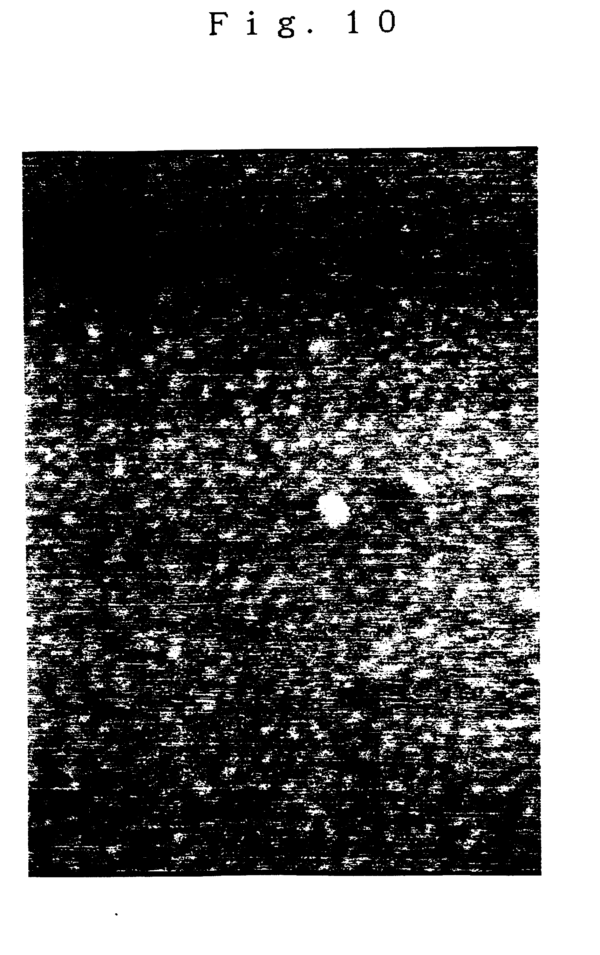

Next, SEM images were observed. Fig. 8 shows an SEM image of a film prepared without excitation at room temperature. This film is made of relatively large crystal grain with clear grain boundary. Fig. 9 is an SEM image of a film prepared at applied voltage of 8V, showing that the film is made of small grains with obscure boundary and smooth surface. Fig. 10 is a SEM image of a film prepared at applied voltage of 9V. The film has relatively large crystal grains with clear boundary.

Thus, it was found in this embodiment that exciting the crystal growth surface makes crystal grain small and the crystal surface smooth.

### (Embodiment 2)

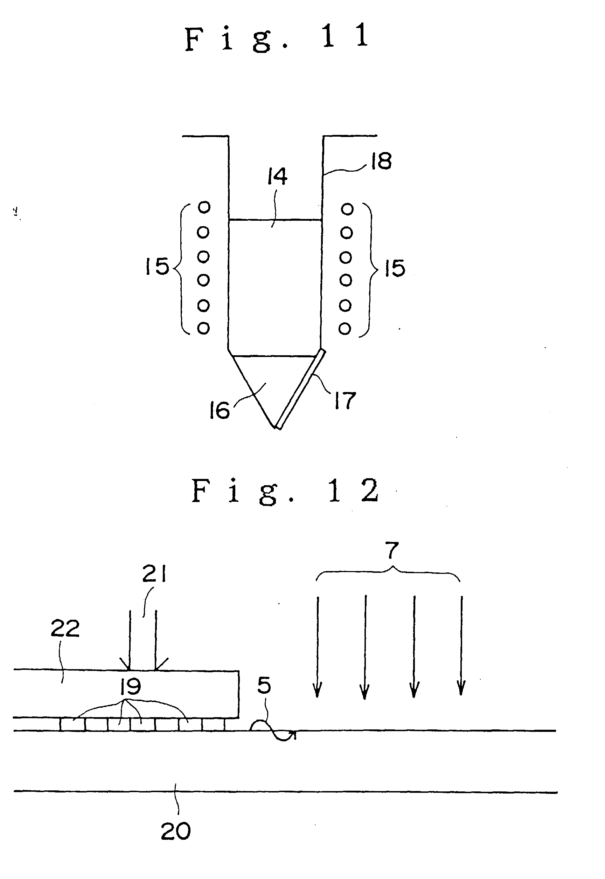

Fig. 11 is a sectional view of a Czochralski type single crystal forming furnace in accordance with the 2nd embodiment. A material is placed in a crucible 18 and heated by a heater 15. The melt of the material is in contact with a single crystal 16. An ultrasonic oscillator 17 is fixed to the bottom of the crucible 18. The mechanical oscillation generated by an ultrasonic oscillator 17 reaches the crystal growth surface and causes the smoothness of crystal growth plane. As a result, a high quality single crystal can be formed. The reason is not clear yet why the quality of the crystal is improved by oscillation, but it may be attributed to the increase in collision probability between atoms or molecules.

According to embodiment 2, it becomes possible to form a single crystal with high quality and high uniformity. In other words, contrary to a prior art single crystal pulling method wherein it has been thought to be important to keep solid-liquid interface ( i.e., interface between a seed crystal and melt) as stationary as possible in order to prepare a high quality single crystal, in this invention, homogeneous high quality single crystal could be prepared by oscillating the interface.

### (Embodiment 3)

The same apparatus as shown in embodiment 2 was used. In this embodiment, a material contains a second element ( and others) more than solid solubility limit. Though, in general, it is thought to be difficult to mix the element more than solubility limit, it becomes possible by using the apparatus of this embodiment to produce composite containing the second element homogeneously. Similar effect can be expected in the case other than single crystal, i.e., in the case that no seed crystal is used. For example, it is possible to homogeneously introduce the second element and the third element into the thin film deposited from vapor phase without segregation.

### (Embodiment 4)

The fourth embodiment is explained by referring to Fig. 12. This embodiment relates to a method for exciting surface acoustic wave. As mentioned in the first embodiment, interdigital electrodes are constructed on the substrate to generate SAW. Therefore, interdigital electrodes must be constructed on every substrate and connected to external electrodes, resulting in low productivity. In this embodiment, a piezoelectric substrate 22 with interdigital electrodes 19 was pressed by external force 21 onto a substrate 20 and then SAW 5 was excited. A thin film is prepared by flow of particles on the substrate 20 which is being excited by SAW.

Thus, this embodiment can be preferably used in mass production because it is unnecessary to construct interdigital electrodes on every substrate.

### (Embodiment 5)

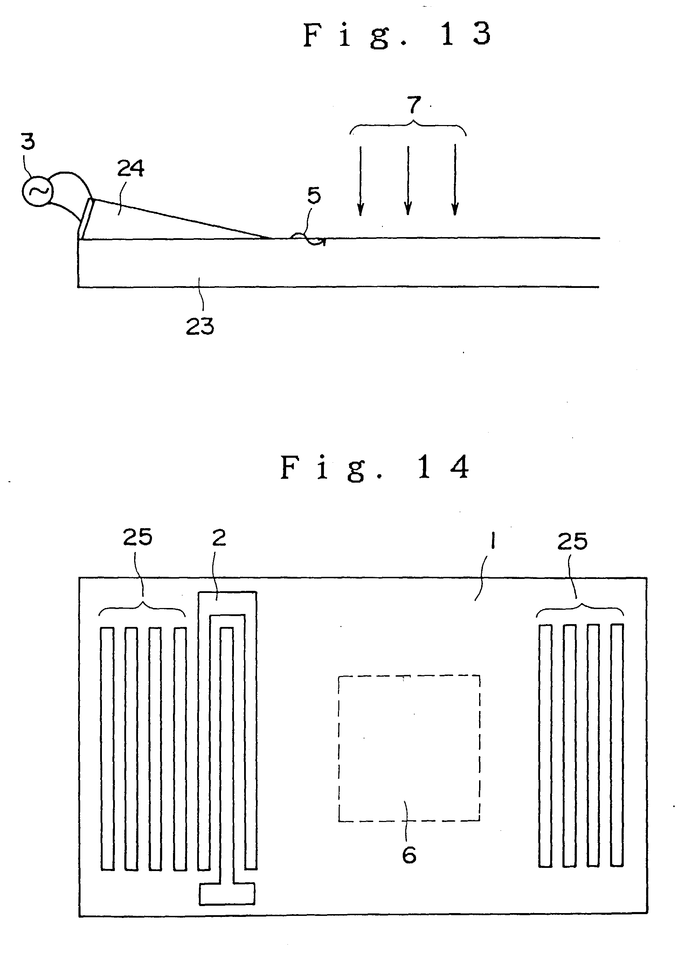

In the first embodiment, the substrate is required to be piezoelectric. In the fourth embodiment, efficiency of excitation is low though SAW can be generated on a non-piezoelectric substrate. This embodiment shown in Fig. 13 provides a method to solve these problems. An oscillator is attached to the surface of a non-piezoelectric substrate 23. The mechanical oscillation excited by signal source 3 propagates as SAW. A thin film is formed on the substrate under oscillation by flow of particles 7 as mentioned above.

By using this embodiment various types of substrates can be used because no piezoelectric substrates are required.

### (Embodiment 6)

Fig. 14 shows embodiment 6. Reflectors 25 are prepared on both sides of interdigital electrodes 2 such that stationary wave is generated. Therefore, node and loop appear in SAW and one-dimensional alternating pattern of large and small crystal grains is formed in an area 6. And since the energy of SAW is confined between the reflectors 25, larger amplitude of excitation can be generated with less voltage. Furthermore, acoustic absorbers become unnecessary by making the reflection coefficient of reflector 25 large. This means that the rise in substrate temperature is suppressed because of decrease in energy to be converted to heat. The high reflection coefficient is attained by increasing the number of lines of the reflectors.

According to this embodiment, the formation of one-dimensional pattern of thin film becomes possible with preventing the substrate temperature from rising. This means that the degree of freedom in preparing thin films increases.

### (Embodiment 7)

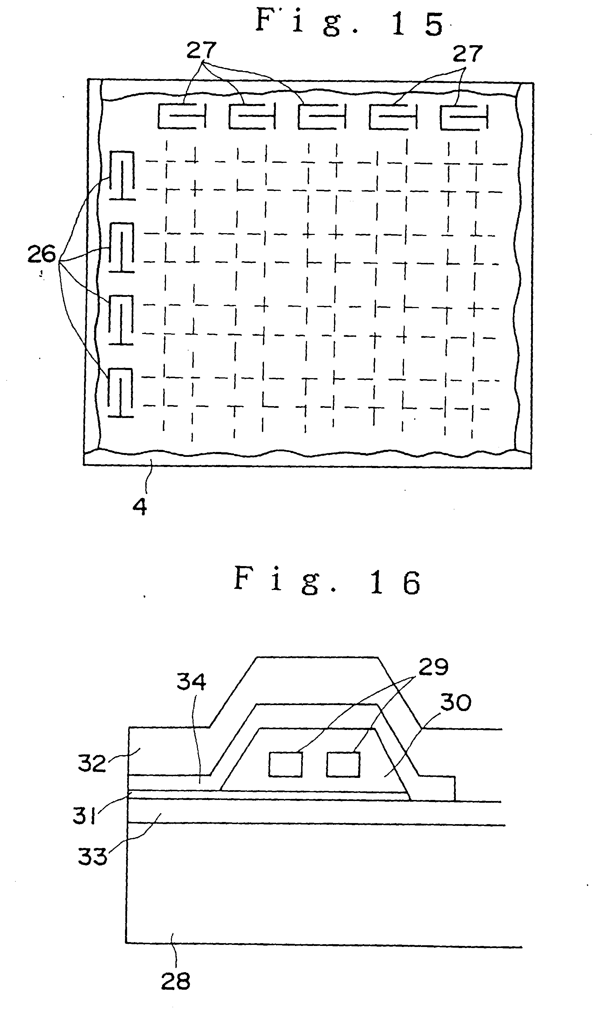

The seventh embodiment is explained by referring to Fig. 15. The formation of one-dimensional pattern was carried out in embodiment 6. This embodiment makes the formation of a two-dimensional pattern possible. Two groups of a plurality of interdigital electrodes 26 and 27 are constructed in the directions of Y axis and X axis in order to two-dimensionally control the quality of a thin film. In other words, the amplitudes of SAW generated by interdigital electrodes 26 and 27 are adjusted 1,0-3,0 nm (10 -30 Å), each amplitude being adjusted to the value not more than 1,5 nm (15 Å). Furthermore, by scanning each excitation, it is possible to control crystal morphology in any case. In the case that only one group of electrodes is constructed, the one-dimensional control of crystal morphology can be attained as mentioned in embodiment 6.

As mentioned above, two-dimensional control of crystal morphology becomes possible. Thus, this method is preferably used for formation of two-dimensional devices such as integrated circuits.

### (Embodiment 8)

The eighth embodiment is explained by referring to Fig. 16. Fig. 16 shows a sectional view of a thin film head prepared by this embodiment.

At first, a lower core 33 is prepared as a substrate being excited by SAW. The grain size of the film thus prepared was so fine that the permeability of the film was very high. Then, after a gap member 31, a coil 29 and an insulator 30 are formed, an upper core 34 is prepared under the excitation by SAW as well as the lower core 33 to make the permeability of the core higher. Finally, a passivation film 32 is prepared and then diced to the head by a dicing apparatus.

This embodiment make it possible to produce a high permeability thin film head with high efficiency of recording and reproducing characteristics.

### (Embodiment 9)

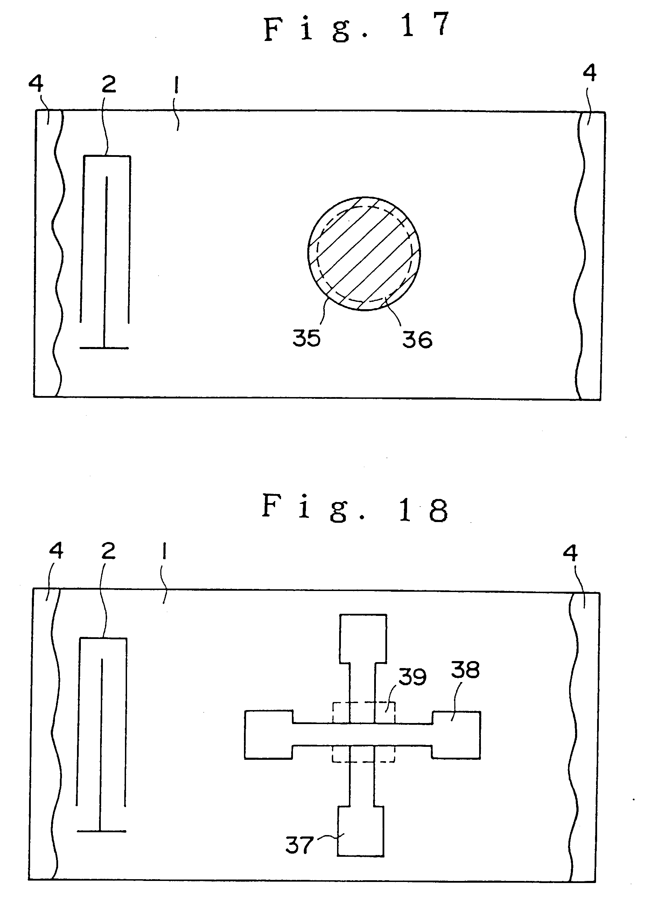

Embodiment 9 is explained by referring to Fig. 17 illustrating a preparing method of a hard magnetic disk as a magnetic memory medium device. Interdigital electrodes 2 and acoustic absorbers 4 are prepared on a piezoelectric substrate 1. A thin film of hard material is prepared on the area 35 as the substrate is being excited by SAW. By this method, the preparation of hard material with fine crystal grain becomes possible and therefore a thin film with short coherent length can be prepared. Next, the magnetic disk is constructed by e.g., an ultrasonic fabrication.

Thus, it becomes possible by this embodiment to construct a magnetic disk with short coherent length, i.e., high recording density.

### (Embodiment 10)

The tenth embodiment is explained by referring to Fig. 18 which illustrates a method to prepare interconnector pattern of integrated circuit. In the figure, only the primary portion is shown. As well as in embodiment 1, interdigital electrodes 2 and acoustic absorbers 4 are formed on a piezoelectric substrate 1, and then lower interconnector 37, interlayer insulator 39 and upper interconnector 38 are prepared on the substrate excited by SAW. By the excitation of SAW, the crystal grain of the film is so fine that the interconnector has high resistance to migration and high bonding strength, and that the insulator has high dielectric breakdown strength.

Thus, it becomes possible by this embodiment that reliable interconnectors are prepared for use in integrated circuits.

### (Embodiment 11)

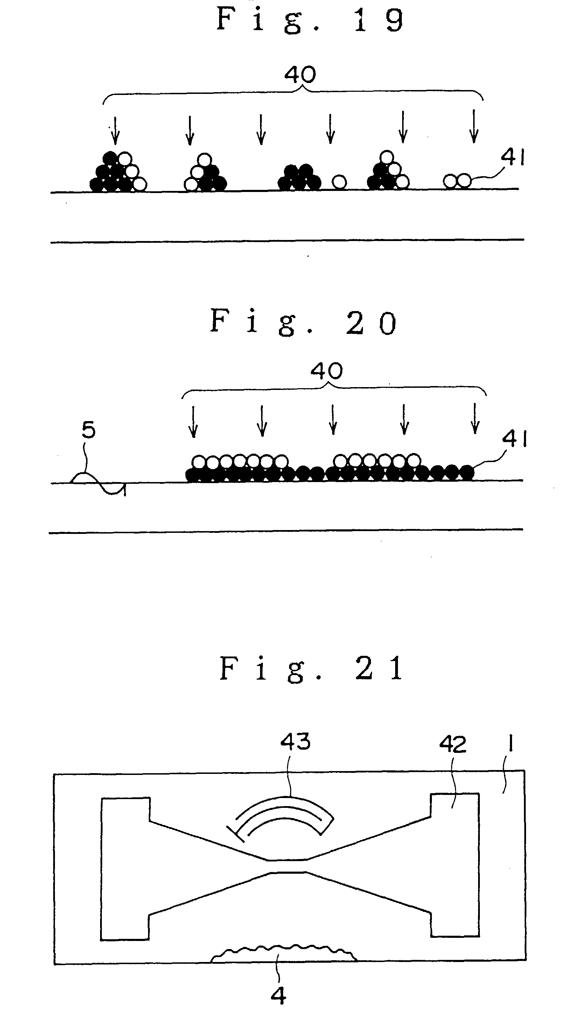

The 11th embodiment of the invention is explained by referring to Figures 19 and 20.

Fig. 19 shows a thin film forming process by a prior art MBE method. In the prior art method, it is difficult to form a superlattice, especially of metal. A flow of the evaporated atoms 40 reached a substrate and, as shown in the figure, every atomic layer is composed of both atoms 41 (black and white circles mean A atom and B atom, respectively); for example, the atom A enters into both the 2nd and 3rd atomic layer. Fig. 20 shows a method to prepare superlattice of the present invention. A thin film is prepared as the substrate being excited by SAW as mentioned above, resulting in the formation of a superlattice with high quality as a result of increase in the smoothness of the surface of every layer.

Thus, it is possible by this embodiment to prepare a superlattice which has been commonly difficult to prepare by the prior art.

### (Embodiment 12)

The 12th embodiment of the invention is explained by referring to Figure 21.

Fig. 21 shows a superconductor thin film prepared by the present invention. As well as in embodiment 1, interdigital electrodes 43 and acoustic absorbers 4 are formed on a piezoelectric substrate 1, and then a superconductor thin film 42 is prepared on the substrate excited by SAW. Interdigital electrodes 43 are prepared in arc shape so that SAW can be focused on a point where the thin film with fine crystal grain and short coherent length can be prepared. Therefore, since superconductivity is weakened, a Josephson bonding can be easily constructed there.

Thus, it is possible by this embodiment to reproduce a Josephson bonding relatively easily and reliably.

### (Embodiment 13)

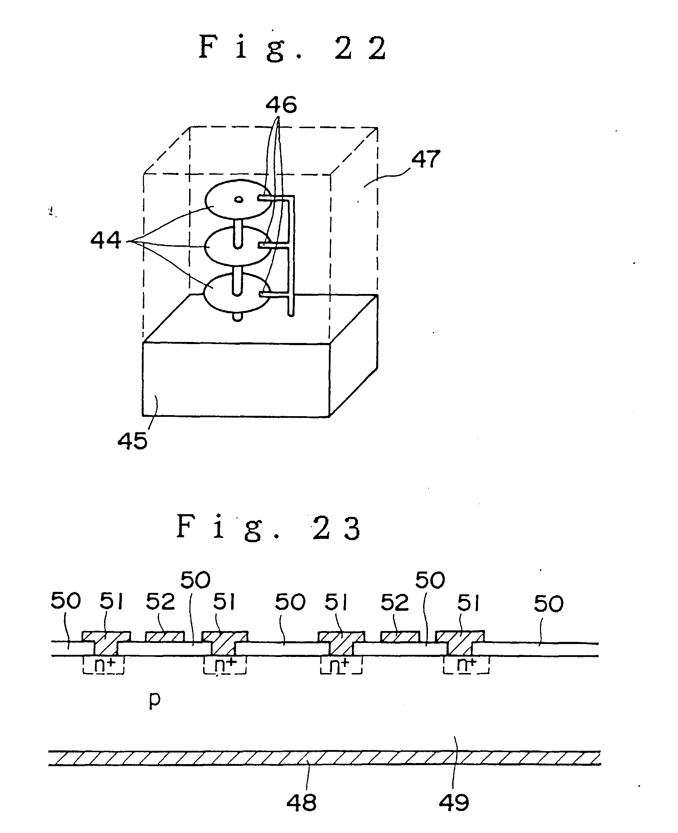

The 13th embodiment of the invention is explained by referring to Figure 22 which illustrates a magnetic recording and reproducing apparatus having a hard magnetic disk of the present invention. In this embodiment, an external memory unit 47 used for controlling instruments is constructed in which a controller 45 controls the movement of the magnetic disk 44 prepared by embodiment 9 and the thin film head 46 prepared by embodiment 8.

Thus, it becomes possible to construct the external memory unit with low error rate and large recording capacity.

### (Embodiment 14)

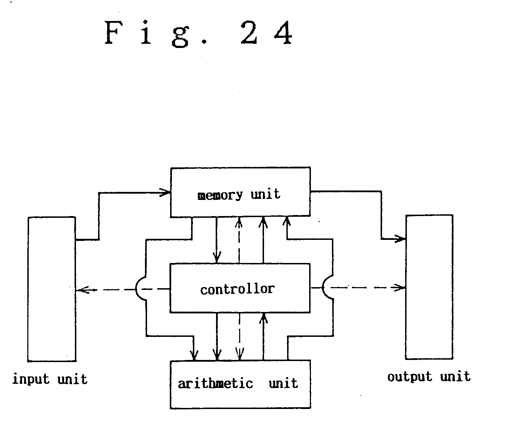

The 14th embodiment of the invention is explained by referring to Fig. 23 which illustrates a fragmentary sectional view of a part of an integrated circuit prepared by the invention. The figure shows a MOSFET. An SiO₂ film 50 and a conductive film 48 are formed on the front surface and on the back surface of a p-type silicon substrate 49, respectively. Then, in the same manner as embodiment 10, source and drain electrodes 51, gate electrode 52, interconnector and interlayer insulator are formed as the substrate is being excited by SAW, producing the devices having high resistance to migration.

Thus, it becomes possible by this embodiment to construct the integrated circuit with high reliability and long lifetime.

### (Embodiment 15)

The 15th embodiment of the invention is explained by referring to Fig. 24 which illustrates a block diagram of a computer system of the present invention.

Information data inputted through a key board and other input units are sent to and stored in a memory unit under the control of a controller. The information data stored in the memory unit is processed by an arithmetic unit and the results are stored in the memory unit under the control of the controller. Then, the results are outputted through an output unit. In the figure, solid lines mean flow of information data and the broken lines the control. Here, the magnetic disk apparatus of the embodiment 13 and the integrated circuit of the embodiment 14 are used as a memory unit and an arithmetic unit, respectively. By using these apparatus, high reliability and large memory capacity can be attained.

Thus, it is possible to provide an information processing apparatus with high reliability and large memory capacity.

### APPLICATION TO INDUSTRIES

As mentioned above, the present invention makes it possible to control the crystal growth of thin films and bulk materials and therefore to manufacture various types of materials with high quality. Consequently, high reliability, high efficiency and large capacity of the apparatus can be attained.

## Claims

1. A method for preparing a crystal thin film on a surface of a substrate of one of a semiconductor device, magnetic device, and superconductor device, wherein said crystal thin film is prepared by one of sputtering, evaporation, and chemical vapor deposition and is deposited as said substrate or said surface of said substrate is being excited by a surface acoustic wave, wherein the amplitude of the surface acoustic wave excitation is in the range of 1.5 to 3.0 nm (15 to 30 Å).

2. The method according to claim 1, wherein said substrate is piezoelectric.

3. The method according to claim 1, wherein said surface acoustic wave is a stationary wave.

4. An apparatus for preparing a crystal thin film on a surface of a substrate of one of a semiconductor device, magnetic device, and superconductor device, comprising a means for exciting the surface of the substrate by a surface acoustic wave, said exciting means comprising only one interdigital electrode disposed on a first end of the surface on which said crystal thin film is deposited, and an acoustic absorber for reducing the reflection of the surface acoustic wave, said acoustic absorber disposed on a second end of the surface opposite said exciting means, whereby the crystal thin film is deposited in the area between said exciting means and said acoustic absorber.

5. The apparatus according to claim 4, wherein said exciting means comprises an interdigital electrode and a means for applying a voltage to said interdigital electrode.

6. The apparatus according to claim 5, wherein said interdigital electrode in use is fixed on said substrate.

7. The apparatus according to claim 5, wherein said interdigital electrode is formed on a piezoelectric member and said piezoelectric member which in use is brought in contact with said substrate.

8. The apparatus according to claim 5, wherein said interdigital electrode is formed in an arc shape.

9. The apparatus according to claim 4, wherein said exciting means is a wedge-shaped oscillator.

10. The apparatus according to claim 9, wherein said substrate is non-piezoelectric.

11. The apparatus according to claim 4, wherein a plurality of said exciting means are provided.

12. The apparatus according to claim 11, wherein a plurality of said exciting means are disposed such that in use the substrate can be excited two-dimensionally,

13. A device comprising a substrate and a crystal thin film with at least one layer prepared thereon, wherein at least one layer of said crystal thin film is prepared according to the method of one of the claims 1-3.

14. A device according to claim 13, wherein said crystal thin film is soft magnetic.

15. A device according to claim 13, wherein said crystal thin film is hard magnetic.

16. A device according to claim 13, wherein said crystal thin film is a metal or a metal alloy.

17. A device according to claim 13, wherein said crystal thin film is an insulator.

18. A device according to claim 13, wherein said crystal thin film is a superlattice.

19. A device according to claim 13, wherein said crystal thin film is a superconductor.

20. An electric and magnetic apparatus constructed by integrating a device comprising a substrate and a crystal thin film with at least one layer prepared thereon, wherein at least one layer of said thin film is prepared according to the method of one of the claims 1-3.

21. An electric and magnetic apparatus according to claim 20, wherein said device is a semiconductor device.

22. An electric and magnetic apparatus according to claim 21, wherein said semiconductor device is a MOSFET and a gate insulator and interconnector thereof are prepared according to the method of claims 1-3 as the surface of said substrate is being excited.

23. An electric and magnetic apparatus according to claim 21, wherein said apparatus is an information memory medium device and a recording layer thereof is prepared according to the method of claims 1-3 as the surface of said substrate is being excited.

24. An electric and magnetic apparatus according to claim 21, wherein said apparatus is a recording head for recording information onto and reproducing information from an information memory medium device, wherein core of said recording head is prepared according to the method of claims 1-3 as the surface of said substrate is being excited.

25. An information recording and reproducing apparatus comprising the information memory medium device defined in claim 23 and the recording head defined in claim 24.

26. An information processing apparatus for use in input, record, process and output of information comprising a recording portion having the information memory medium device defined in claim 23 and a processing portion having the semiconductor device defined in claim 21.

## Patentansprüche

1. Verfahren zur Herstellung eines dünnen Kristallfilmes auf der Oberfläche eines Substrates eines Halbleiterbauelementes, eines magnetischen Bauelementes oder eines supraleitenden Bauelementes, wobei der dünne Kristallfilm durch Aufsputtern, Aufdampfen oder durch ein chemisches Aufdampfverfahren hergestellt wird und wobei das Substrat oder die Oberfläche des Substrates beim Abscheiden des dünnen Kristallfilmes auf der Substratoberfläche durch eine akustische Oberflächenwelle angeregt wird, deren Amplitude 1,5 bis 3,0 nm (15 bis 30 Å) beträgt.

2. Verfahren nach Anspruch 1, wobei als Substrat ein piezoelektrisches Substrat verwendet wird.

3. Verfahren nach Anspruch 1, wobei die akustische Oberflächenwelle eine stationäre Welle ist.

4. Vorrichtung zur Herstellung eines dünnen Kristallfilmes auf der Oberfläche eines Substrates eines Halbleiterbauelementes, eines magnetischen Bauelementes oder eines supraleitenden Bauelementes mit folgenden Bauteilen: eine Einrichtung zur Anregung der Oberfläche des Substrates durch eine akustische Oberflächenwelle, wobei diese Anregungseinrichtung lediglich eine Interdigitalelektrode umfaßt, die an einem ersten Ende der Oberfläche angeordnet ist, auf der der dünne Kristallfilm abgeschieden wird; und eine akustische Absorptionseinrichtung zur Verringerung der Reflexion der akustischen Oberflächenwelle, wobei diese akustische Absorptionseinrichtung gegenüberliegend zu der Anregungseinrichtung an einem zweiten Ende der Oberfläche angeordnet ist, und wobei der dünne Kristallfilm in dem Bereich zwischen der Anregungseinrichtung und der akustischen Absorptionseinrichtung abgeschieden wird.

5. Vorrichtung nach Anspruch 4, wobei die Anregungseinrichtung eine Interdigitalelektrode und eine Einrichtung zum Anlegen einer Spannung an die Interdigitalelektrode umfaßt.

6. Vorrichtung nach Anspruch 5, wobei die Interdigitalelektrode in Betrieb auf dem Substrat befestigt ist.

7. Vorrichtung nach Anspruch 5, wobei die Interdigitalelektrode auf einem piezoelelektrischen Bauteil ausgebildet, das im Betrieb in Kontakt mit dem Substrat gebracht wird.

8. Vorrichtung nach Anspruch 5, wobei die Interdigitalelektrode bogenförmig ausgebildet ist.

9. Vorrichtung nach Anspruch 4, wobei die Anregungseinrichtung ein keilförmiger Oszillator ist.

10. Vorrichtung nach Anspruch 9, wobei das Substrat nicht piezoelektrisch ist.

11. Vorrichtung nach Anspruch 4_{,} wobei mehrere Anregungseinrichtungen vorhanden sind.

12. Vorrichtung nach Anspruch 11, wobei die mehreren Anregungseinrichtungen so angeordnet sind, daß das Substrat durch Betrieb der Anregungseinrichtungen zweidimensional anregbar ist.

13. Bauelement mit einem Substrat und einem auf dem Substrat aufgebrachten zumindest einschichtigen dünnen Kristallfilm, wobei zumindest eine Schicht des dünnen Kristallfilms durch ein Verfahren nach einem der Ansprüche 1 bis 3 hergestellt wurde.

14. Bauelement nach Anspruch 13, wobei der dünne Kristallfilm weichmagnetisch ist.

15. Bauelement nach Anspruch 13, wobei der dünne Kristallfilm hartmagnetisch ist.

16. Bauelement nach Anspruch 13, wobei der dünne Kristallfilm aus einem Metall oder einer Metallegierung besteht.

17. Bauelement nach Anspruch 13, wobei der dünne Kristallfilm ein Isolator ist.

18. Bauelement nach Anspruch 13, wobei der dünne Kristallfilm ein Übergitter umfaßt.

19. Bauelement nach Anspruch 13, wobei der dünne Kristallfilm ein Supraleiter ist.

20. Elektromagnetische Vorrichtung, die unter Integration eines Bauelementes gestaltet wurde, das ein Substrat und einen auf dem Substrat aufgebrachten zumindest einschichtigen dünnen Kristallfilm umfaßt, wobei zumindest eine Schicht dieses dünnen Filmes durch ein Verfahren nach einem der Ansprüche 1 bis 3 hergestellt wurde.

21. Elektromagnetische Vorrichtung nach Anspruch 20, wobei das Bauelement ein Halbleiterbauelement ist.

22. Elektromagnetische Vorrichtung nach Anspruch 21, wobei das Halbleiterbauelement ein MOSFET ist, dessen Gate, Isolator und Verbindungsschicht durch ein Verfahren nach einem der Ansprüche 1 bis 3 unter Anregung der Oberfläche hergestellt wurde.

23. Elektromagnetische Vorrichtung nach Anspruch 21, wobei die Vorrichtung ein aus einem Informationsspeichermedium bestehendes Bauelement mit einer Aufzeichnungs- oder Speicherschicht ist, die durch ein Verfahren nach einem der Ansprüche 1 bis 3 unter Anregung der Substratoberfläche hergestellt wurde.

24. Elektromagnetische Vorrichtung nach Anspruch 21, wobei die Vorrichtung ein Aufzeichnungskopf zum Aufzeichnen von Informationen auf ein aus einem Informationsspeichermedium bestehendes Bauelement und zum Gewinnen von Informationen von diesem Bauelement ist, wobei der Kern dieses Aufzeichnungskopfes nach einem Verfahren nach einem der Ansprüche 1 bis 3 unter Anregung der Substratoberfläche hergestellt wurde.

25. lnformationsaufzeichnungs- und Wiedergabevorrichtung mit einem aus einem Informationsspeichermedium bestehenden Bauelement nach Anspruch 23 und einem Aufzeichnungskopf nach Anspruch 24.

26. Informationsverarbeitungsvorrichtung zur Eingabe, Aufzeichnung, Verarbeitung und Ausgabe von Informationen mit einem Aufzeichnungs- oder Speicherteil, der ein aus einem Informationsspeichermedium bestehendes Bauelement nach Anspruch 23 umfaßt, und mit einem Verarbeitungsteil, der ein Halbleiterbauelement nach Anspruch 21 umfaßt.

## Revendications

1. Méthode pour la préparation d'une couche mince de cristal sur une surface d'un substrat d'un dispositif à semi-conducteur, d'un dispositif magnétique et d'un dispositif supraconducteur où la-dite couche mince de cristal est préparée par une pulvérisation cathodique, évaporation et déposition en phase gazeuse par voie chimique et est déposée lorsque le-dit substrat ou la-dite surface est excité(e) par une onde acoustique de surface où l'ampitude de l'onde acoustique de surface est comprise entre 1,5 et 3.0 nm (15 à 30 Å).

2. Méthode conformément à la revendication 1 caractérisée en ce que le-dit substrat est piézo-électrique.

3. Méthode conformément à la revendication 1 caractérisée en ce que la-dite onde acoustique de surface est une onde stationnaire

4. Appareil pour préparer une couche mince de cristal sur une surface d'un substrat d'un dispositif à semi-conducteur, d'un dispositif magnétique et d'un dispositif supraconducteur comprenant un moyen pour exciter la surface du substrat au moyen d'une onde acoustique de surface, le-dit moyen d'excitation comprenant une seule électrode interdigitale disposée sur un premier bout de la surface sur laquelle la-dite couche mince de cristal est déposée et un absorbeur acoustique pour réduire la réflexion de l'onde acoustique de surface, le-dit absorbeur acoustique étant disposé à un second bout de la surface, à l'opposé du-dit moyen d'excitation, la couche mince de cristal étant déposée dans la zone comprise entre le-dit moyen d'excitation et le-dit absorbeur acoustique.

5. Appareil conformément à la revendication 5 caractérisé en ce que le-dit moyen d'excitation comprend une électrode interdigitale et un moyen pour appliquer une tension à la-dite électrode interdigitale.

6. Appareil conformément à la revendication 5 caractérisé en ce que ladiite électrode interdigitale utilisée est fixée sur le-dit substrat.

7. Appareil conformément à la revendication 5 caractérisé en ce que la-dite électrode interdigitale est formée sur un élément piézo-électrique et que Ile-dit élément piézo-électrique, lorsqu'il est utilisé, est amené en contact avec le-dit substrat.

8. Appareil conformément à la revendication 5 caractérisé en ce que la-dite électrode interdigitale est formée sous forme d'arc.

9. Appareil conformément à la revendication 4 où le-dit moyen d'excitation est un oscillateur en forme de coin.

10. Appareil conformément à la revendication 9 où le-dit substrat est non piézo-électrique.

11. Appareil conformément à la revendication 4 où il y a une pluralité des-dits moyens d'excitation

12. Appareil conformément à la revendication 11 où une pluralité des-dits moyens d'excitation sont disposés de telle sorte qu'en utilisation, le substrat puisse être excité dans deux dimensions.

13. Dispositif comprenant un substrat et une couche mince de cristal avec au moins une couche préparée dessus où au moins une couche de la-dite couche mince de cristal est préparée conformément à la méthode de l'une des revendications 1 à 3.

14. Dispositif conformément à la revendication 13 où la-dite couche mince de cristal est de type magnétique doux.

15. Dispositif conformément à la revendication 13 où la-dite couche mince de cristal est de type magnétique dur.

16. Dispositif conformément à la revendication 13 où la-dite couche mince de cristal est un métal ou un alliage métallique.

17. Dispositif conformément à la revendication 13 où la-dite couche mince de cristal est un isolant.

18. Dispositif conformément à la revendication 13 où la-dite couche mince de cristal est une surstructure.

19. Dispositif conformément à la revendication 13 où la-dite couche mince de cristal est un supraconducteur.

20. Dispositif électrique et magnétique construit en intégrant un appareil comprenant un substrat et une couche mince de cristal avec au moins une couche préparée dessus où au moins une couche de la-dite couche mince de cristal est préparée selon la méthode d'au moins l'une des revendications 1 à 3.

21. Dispositif électrique et magnétique conformément à la revendication 20 où le-dit dispositif est un dispositif à semiconducteurs.

22. Dispositif électrique et magnétique conformément à la revendication 21 où le-dit dispositif à semiconducteurs est un MOSFET et un isolant de grille et un interconnecteur sont préparés conformément à la méthode des revendications 1 à 3 quand la surface du-dit substrat est excitée.

23. Dispositif électrique et magnétique conformément à la revendication 21 où le-dit appareil est un dispositif de support de mémorisation d'informations et une couche d'enregistrement de celui-ci est préparée conformément à la méthode des revendications 1 à 3 lorsque que la surface du-dit substrat est excitée.

24. Dispositif électrique et magnétique conformément à la revendication 21 où le-dit appareil est une tête d'enregistrement pour l'enregistrement d'informations et la reproduction d'informations à partir d'un dispositif support de mémorisation d'informations où le noyau de la-dite tête d'enregistrement est préparé conformément à la méthode des revendications 1 à 3 lorsque la surface du-dit substrat est excitée.

25. Appareil d'enregistrement et de reproduction d'informations comprenant le dispositif de support de mémorisation d'informations défini dans la revendication 23 et la tête d'enregistrement définie dans la revendication 24.

26. Appareil de traitement de l'information pour être utilisé pour l'entrée, l'enregistrement, le traitement et la sortie d'informations, comprenant une partie d'enregistrement ayant le dispositif de support de mémorisation des informations défini dans la revendication 23 et une partie de traitement ayant le dispositif à semiconducteurs défini dans la revendication 21.
